(19) Europäisches Patentamt / European Patent Office / Office européen des brevets

(11) **EP 1 437 829 B1**

(12) **EUROPEAN PATENT SPECIFICATION**

(45) Date of publication and mention
of the grant of the patent:
**12.03.2008  Bulletin 2008/11**

(51) Int Cl.:
***H03J 5/24*** *(2006.01)*

(21) Application number: **03405006.2**

(22) Date of filing: **09.01.2003**

(54) **Method and integrated circuit for tuning an LC resonator and electrical apparatus comprising an LC resonator**

Verfahren und Integrierte Schaltung zur Abstimmung eines LC-Resonators und elektrisches Gerät welches einen LC-Resonator enthält

Procédé et circuit intégré pour l'accord d'un résonateur LC et appareil électrique comprenant un résonateur LC

(84) Designated Contracting States:
**CH DE DK LI**

(43) Date of publication of application:
**14.07.2004  Bulletin 2004/29**

(73) Proprietor: **PHONAK COMMUNICATIONS AG**
**1796 Courgevaux (CH)**

(72) Inventors:
• **Callias, Francois**
**2046 Fontaines (CH)**

• **Philp, Reto**
**1004 Lausanne (CH)**
• **Platz, Rainer**
**2000 Nechatel (CH)**

(74) Representative: **BOVARD AG**
**Optingenstrasse 16**
**3000 Bern 25 (CH)**

(56) References cited:
**US-A- 4 138 654        US-A- 5 745 844**
**US-A- 6 070 803        US-B1- 6 317 027**

**Description**

Technical Field

The present invention relates to a method and an integrated circuit for tuning an LC resonator and to an electrical apparatus comprising an LC resonator. Specifically, the present invention relates to a method and an integrated circuit for tuning an LC resonator and to an electrical apparatus comprising an LC resonator, which all use a variable capacitance for tuning the LC resonator.

Background Art

Tuning of LC resonators is often required for LC resonators that are part of a load circuit of a pre-amplifier or an oscillator, for example. Particularly, LC resonators with antenna coils serving as antennas for radio receivers require tuning when the receivers cover a wider frequency range than the antennas.

Miniaturised antennas, respectively antenna coils, with geometrical dimensions that are small compared to the wavelength of received signals generally have a high quality factor Q. On the one hand, the sensitivity of a complete receiver system, comprising a radio receiver and an antenna connected to the receiver, is proportional to the quality factor Q of the antenna. On the other hand, the 3dB bandwidth of an antenna is inversely proportional to the quality factor Q of the antenna. For example, an antenna with a quality factor of Q=100, has a 3dB bandwidth of only ~2 MHz at a frequency of 200 MHz. Therefore, the 3dB bandwidth of a miniaturised antenna is generally much smaller than the tuning range of the receiver.

Consequently, in order to cover the entire frequency range of the receiver with one single antenna, the antenna needs to be tuned when the signal frequency is changed. Typically, antennas are tuned by means of a variable capacitance connected in parallel to the antenna.

In formula (1) the resonance frequency $f_{res}$ of an LC resonator comprising an antenna coil $L_A$ and a parallel tuning capacitance $C_A$ is defined:

$$f_{res} = \frac{1}{2\pi\sqrt{L_A C_A}} \qquad (1)$$

As indicated in formula (2), the resonance frequency $f_{res}$ of the LC resonator can be modified by adding an additional tuning capacitance $C_T$ in parallel:

$$f_{res} = \frac{1}{2\pi\sqrt{L_A(C_A + C_T)}}. \qquad (2)$$

In the patent US 4,862,516 a system for automatically tuning the antenna of a miniature portable communications device is described. According to US 4,862,516 the antenna is tuned by varying the capacitance of a varactor diode connected in parallel to the antenna. The system according to US 4,862,516 is based on the transmission of a tuning mode signal combined with active control of the tuning means for obtaining a maximum signal. The magnitude of the received signal is measured, a tuning control signal is generated and supplied to a D/A converter to effect tuning of the antenna by monitoring the variations in the magnitude of the received signal. The transmission of a tuning mode signal according to US 4,862,516 requires a special transmitter. Generally, the transmission of a tuning signal limits the cross-compatibility between different transmitter-receiver systems as the accurate calibration of the receiver tuning circuit has to be known by the transmitter. In principle, each transmitter-receiver pair would need to be calibrated together. Moreover, owing to the dependency on receiving the special tuning mode signal, it is not possible to have the system automatically and autonomously scan a frequency range and tune the antenna. Finally, active tuning control with a feedback path requires a relatively complex system.

A similar method for active tuning control with feedback is described in the patent US 5,438,688. According to US 5,438,688 the signal strength of the received signal is measured and from the measured signal strength an antenna tuning voltage is derived for controlling the tuning means. According to US 5, 438, 688 a predictor value for coarse tuning is obtained from previous tuning cycles.

In the patent US 5,589,844 another active tuning control system is described wherein the capacitance of capacitive elements is adjusted electromechanically. According to US 5,589,844 initial impedance values are determined for each frequency in an operating range and stored in a non-volatile memory.

In the patent US 5,491,715 another method for actively tuning an antenna based on a feedback signal is described wherein the antenna is tuned to a desired frequency by modifying the value of capacitors connected in parallel to the antenna.

All antenna tuning systems based on active control with a feedback path have the disadvantage of requiring relatively complex active controlling means. When integrating the antenna tuning system on a chip, the complex analog circuitry used for the active controlling means increases both the size of the silicon surface and the power consumption of the chip. Furthermore, whenever the frequency is changed, tuning systems based on active control require time for tuning optimisation which is particularly unfavorable, i.e. time-consuming, when a channel scan is performed. Moreover, if no carrier is present on a channel, the scan could end in an infinite loop, the receiver trying to optimise on a non-existing signal. Similarly, if there is no signal available before tuning, because the antenna is untuned, tuning the antenna by means of an active control mechanism is difficult as the signal to optimise is not available and needs first "to be found."

Disclosure of Invention

It is an object of this invention to provide a method, an integrated circuit and an electrical apparatus which are capable of tuning an LC resonator and which do not have the disadvantages of the prior art. In particular, it is an object of the present invention to provide a method, an integrated circuit and an electrical apparatus capable of automatically tuning a miniaturised antenna over a large frequency band without using active control mechanisms with feedback.

According to the present invention, these objects are achieved particularly through the features of the independent claims. In addition, further advantageous embodiments follow from the dependent claims and the description.

A variable capacitance for tuning the LC resonator is connected in parallel to the LC resonator. In the preferred application, the inductance of the LC resonator comprises an antenna coil, particularly a miniaturised antenna coil.

According to the present invention, the above-mentioned objects are particularly achieved in that at manufacturing time, a maximum resonance frequency of the LC resonator is measured when the variable capacitance connected in parallel to the LC resonator is set to its minimum value and a coded value of the measured maximum resonance frequency is stored in a first memory of a tuning module, and a minimum resonance frequency of the LC resonator is measured when the variable capacitance is set to its maximum value and a coded value of the measured minimum resonance frequency is stored in a second memory of the tuning module. The first and second memories of the tuning module are preferably non-volatile memories. At operations time, a tuning code for setting the variable capacitance to a value that results in a target resonance frequency of the LC resonator is computed as an interpolation between the coded value stored in the first memory and the coded value stored in the second memory for a coded value of the target resonance frequency, and the value of the variable capacitance is adjusted in accordance with the value of the computed tuning code. Advantageously, the LC resonator and correspondingly a miniaturised antenna can be tuned without using active control mechanisms with feedback; there is no need for measuring signal strength and no special tuning mode signal is necessary. The LC resonator and correspondingly the miniaturised antenna can be tuned in the time it takes to perform one single computation. Finally, owing to their reduced complexity, the module for tuning the LC resonator and correspondingly for tuning the miniaturised antenna can be fully integrated on a chip, for example through a CMOS process.

In a preferred embodiment, the variable capacitance connected in parallel to the LC resonator comprises several separate capacitors, and the value of the variable capacitance is adjusted by selectively closing switches associated with each of the separate capacitors in accordance with the value of the determined tuning code. Preferably, the switches are implemented as transistors, and the computing means, the transistors and the separate capacitors are integrated on a chip, for example a CMOS chip. Latest CMOS technologies make it possible to build MOS transistor switches with sufficiently low on-resistance at low supply voltages. Furthermore, these MOS transistors have small parasitic capacitances which makes them appropriate for applications in the VHF and UHF frequency range.

In the preferred embodiment the tuning code is a binary code, the values of the separate capacitors are binary weighted, and the bits composing the tuning code are assigned to the switches associated with the separate capacitors such that the binary weight of each bit corresponds to the binary weight of the separate capacitor associated with the switch. Using a binary tuning code and binary weighted values of the separate capacitors makes possible an extremely simple interconnection of the computing means and the variable capacitance, thereby reducing size and power consumption of the tuning module or its corresponding integrated circuit, respectively.

Preferably, the tuning code is computed as a linear interpolation, comprising computing a ratio of the difference between the coded value stored in the first memory and the coded value of the target resonance frequency and of the difference between the coded value stored in the first memory and the coded value stored in the second memory. Computing the tuning code as a linear interpolation makes it possible to use computing means of very simple complexity, thereby reducing size and power consumption of the tuning module or its corresponding integrated circuit, respectively.

Preferably, the LC resonator comprises a trim capacitor for a one-time simple and straightforward calibration of the LC resonator at manufacturing time. The LC resonator can be calibrated to a desired maximum resonance frequency by disconnecting all the separate capacitors of the variable capacitance and by setting the trim capacitor to the appropriate calibration value. The one-time calibration with local calibration means makes transmission of special tuning signals unnecessary.

Brief Description of Drawings

The present invention will be explained in more detail, by way of example, with reference to the drawings in which:

Figure 1 shows a block diagram illustrating an electrical apparatus with an LC resonator connected to a module for tuning the LC resonator, which module comprises a variable capacitance controlled by computing means.
Figure 2 shows a block diagram illustrating an LC resonator connected to a circuit for tuning the LC resonator, which circuit comprises several separate capacitors selectively connectable in parallel to the LC resonator.

Mode(s) for Carrying Out the Invention

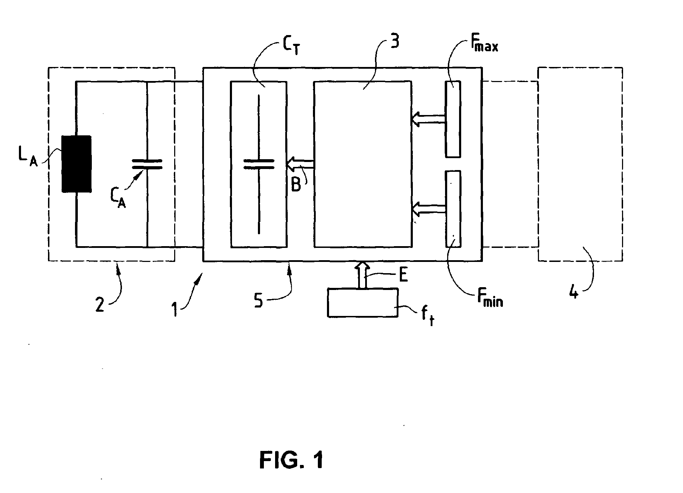

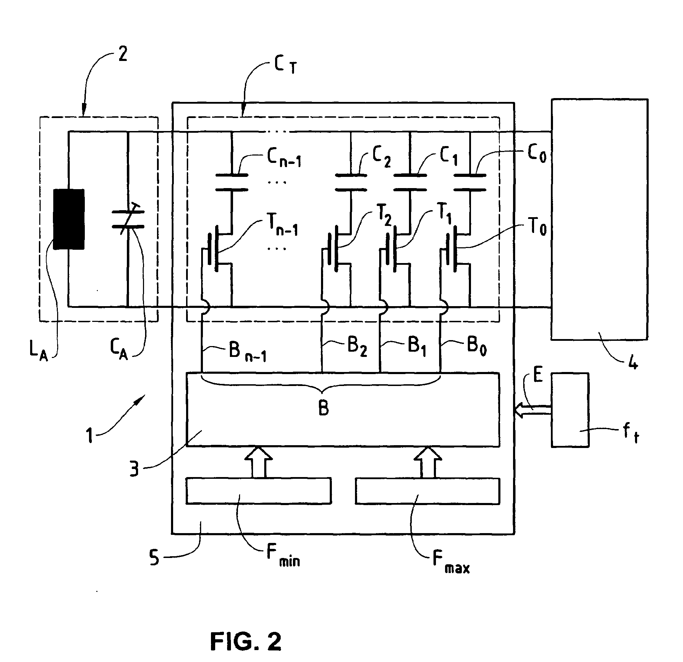

In the Figures 1 and 2, the reference numeral 1 refers to an electrical apparatus comprising an LC resonator 2, a tuning module 5 and an optional radio receiver 4, connected to the LC resonator 2. As is illustrated in Figures 1 and 2, the LC resonator 2 comprises an inductance $L_A$ and a capacitance $C_A$. In a preferred application, the inductance $L_A$ is an antenna coil, particularly a miniaturised antenna coil, connected to the radio receiver 4. The geometrical dimensions of a miniaturised antenna coil are small compared to the wavelength of received radio signals. The miniaturised antenna coil of the inductance $L_A$ is dimensioned for use in preferred applications in the VHF (Very High Frequency, 30 - 300 MHz) or UHF (Ultra High Frequency, 300 MHz - 3 GHz) frequency range. Examples of miniaturised antennas used in preferred applications in the VHF frequency range are air coils with a diameter of approximately 4 mm and with typically 2 to 5 windings or coils wound on ferrite rods with approximate dimensions of $(7\times3\times2)$ mm$^3$. Preferably, the capacitance $C_A$ comprises a trim capacitor, as is illustrated in Figure 2, for calibrating the LC resonator 2 according to formula (1) to the desired maximum resonance frequency at manufacturing time of the electrical apparatus 1.

As is illustrated in Figures 1 and 2, the tuning module 5 comprises a variable capacitance $C_T$ for tuning the LC resonator 2 which is connected in parallel to the LC resonator 2. Furthermore the tuning module 5 comprises memories $F_{max}$ and $F_{min}$ for storing a coded value of a maximum resonance frequency and a coded value of a minimum resonance frequency, respectively, and computing means 3. The memories $F_{max}$ and $F_{min}$ are preferably non-volatile memories, for example, EPROM or EEPROM. The computing means 3 are preferably implemented as non-programmable logic circuits. Alternatively, the computing means can be implemented by means of programmable logic circuits or by means of a combination of a processor and program code. Finally, the tuning module 5 comprises an interface E for receiving a coded value of a target resonance frequency $f_t$. The coded value of the target resonance frequency $f_t$ can be input by means of an operating element, such as a dial, or by means of a wireless receiver receiving the coded value of the target resonance frequency $f_t$ via electromagnetic waves from an external remote control. Alternatively, the interface E may also be part of a hard wired or programmable core command unit of the device 1. This core command unit may be provided with the input means mentioned above, e.g. with operating elements or wireless receivers, or else, the target resonance frequency $f_t$ may be generated within the core command unit. The values of the frequencies can be coded as binary frequency codes or as decimal values or according to another coding scheme.

As will be explained later in detail, the computing means 3 compute a tuning code B for adjusting the value of the tuning capacitance $C_T$. As is illustrated in Figure 1, the tuning code B output by the computing means 3 is passed to the tuning capacitance $C_T$.

In a possible embodiment, the tuning capacitance $C_T$ comprises a capacitive varactor diode connected to a D/A-converter (Digital/Analog) receiving the tuning code B output by the computing means 3.

In the preferred embodiment illustrated in Figure 2, the tuning capacitance $C_T$ comprises several separate capacitors $C_{n-1}, ..., C_2, C_1, C_0$. Each one of the separate capacitors $C_{n-1}, ..., C_2, C_1, C_0$ is connected in series to an associated switch $T_{n-1}, ..., T_2, T_1, T_0$. The switches $T_{n-1}, ..., T_2, T_1, T_0$ are preferably transistors. The separate capacitors $C_{n-1}, ..., C_2, C_1, C_0$ can each be selectively connected in parallel to the LC resonator 2 by closing its associated switch $T_{n-1}, ..., T_2, T_1, T_0$ or disconnected by opening its associated switch $T_{n-1}, ..., T_2, T_1, T_0$, respectively. The control gates of the switches $T_{n-1}, ..., T_2, T_1, T_0$ are connected to the outputs $B_{n-1}, ..., B_2, B_1, B_0$ of the computing means 3, each output $B_{n-1}, ..., B_2, B_1, B_0$ representing one bit of the tuning code B. A high value (ON: bit="1") on an output $B_{n-1}, ..., B_2, B_1, B_0$ closes, and a low value (OFF: bit="0") on an output $B_{n-1}, ..., B_2, B_1, B_0$ opens, the respective switch $T_{n-1}, ..., T_2, T_1, T_0$. Preferably, the tuning code B is a binary code, and the values of the separate capacitors $C_{n-1}, ..., C_2, C_1, C_0$ are binary weighted. The binary weight of each separate capacitor $C_{n-1}, ..., C_2, C_1, C_0$ corresponds to the binary weight of the bit of the tuning code represented on the output $B_{n-1}, ..., B_2, B_1, B_0$ that is controlling the switch $T_{n-1}, ..., T_2, T_1, T_0$ connected to the respective separate capacitor $C_{n-1}, ..., C_2, C_1, C_0$. Hence the total value of the capacitance of the

separate capacitors $C_{n-1}$, ..., $C_2$, $C_1$, $C_0$ connected in parallel to the LC resonator 2 corresponds to the value of the binary tuning code B output by the computing means 3.

The tuning module 5 is preferably implemented as an integrated circuit on a chip. Preferably, the separate capacitors $C_{n-1}$, ..., $C_2$, $C_1$, $C_0$, the switches $T_{n-1}$, ..., $T_2$, $T_1$, $T_0$, the computing means 3 and the memories $F_{max}$ and $F_{min}$ are manufactured in CMOS (Complementary Metal-Oxide-Semiconductor) technology. The tuning module 5 and the radio receiver 4 can be implemented on one common chip or on separate chips.

At manufacturing time of the electrical apparatus 1, the variable capacitance $C_T$ is set to its minimum value, i.e. in the preferred embodiment, all the separate capacitors $C_{n-1}$, ..., $C_2$, $C_1$, $C_0$ are disconnected by opening all the switches $T_{n-1}$, ..., $T_2$, $T_1$, $T_0$ (i.e. tuning code B='0...000'). Then the LC resonator 2 is calibrated to a desired maximum resonance frequency by adjusting the value of the capacitance $C_A$. The calibrated maximum resonance frequency of the LC resonator 2 is measured by means of an external measuring device and stored as a coded value in the memory $F_{max}$ of the tuning module 5. From the external measuring device, the coded value of the maximum resonance frequency can be stored in the memory $F_{max}$ via the interface E, for example.

Thereafter, the variable capacitance $C_T$ is set to its maximum value, i.e. in the preferred embodiment, all the separate capacitors $C_{n-1}$, ..., $C_2$, $C_1$, $C_0$ are connected in parallel to the LC resonator by closing all the switches $T_{n-1}$, ..., $T_2$, $T_1$, $T_0$ (i.e. tuning code B='1...111'). At this setting, the minimum resonance frequency of the LC resonator 2 is measured and stored as a coded value in the memory $F_{min}$ of the tuning module 5. From the external measuring device, the coded value of the minimum resonance frequency can be stored in the memory $F_{min}$ via the interface E, for example.

During operation of the electrical apparatus 1, a target resonance frequency $f_t$ is input through the interface E to the computing means 3. The computing means 3 retrieve the coded value of the maximum resonance frequency stored in the memory $F_{max}$ and the coded value of the minimum resonance frequency stored in the memory $F_{min}$, and compute a tuning code B as an interpolation between the coded value of the maximum resonance frequency and the coded value of the minimum resonance frequency for the received coded value of the target resonance frequency $f_t$.

In its simplest form the computation can be a linear interpolation according to formula (3), $f_{max}$ and $f_{min}$ representing the values stored in the memories $F_{max}$ and $F_{min}$:

$$B = \frac{f_{\max} - f_t}{f_{\max} - f_{\min}} \qquad (3)$$

In the embodiment where the capacitance $C_T$ comprises several separate capacitors $C_{n-1}$, ..., $C_2$, $C_1$, $C_0$, the value of the variable capacitance $C_T$ corresponds to the sum of all the separate capacitors $C_{n-1}$, ..., $C_2$, $C_1$, $C_0$ connected in parallel to the LC resonator 2, as defined in formula (4), wherein B[i] corresponds to the bits of the tuning code B on the outputs $B_{n-1}$, ..., $B_2$, $B_1$, $B_0$:

$$C_T = \sum_{i=0}^{n-1} C_i \cdot B[i] \ . \qquad (4)$$

In the case of binary coding of the frequency values $f_{max}$, $f_{min}$ and $f_t$, the tuning code B, having the most significant bit B[n-1] and the least significant bit B[0], is determined according to formula (5), wherein BIN[x] is the binary expression of x:

$$B[n-1:0] = BIN\left[ \frac{f_{\max} - f_t}{f_{\max} - f_{\min}} \cdot (2^n - 1) \right] \qquad (5)$$

The tuning code B[n-1:0] computed by the computing means 3 is assigned to the outputs $B_{n-1}$, ..., $B_2$, $B_1$, $B_0$, the switches $T_{n-1}$, ..., $T_2$, $T_1$, $T_0$ controlled by an output $B_{n-1}$, ..., $B_2$, $B_1$, $B_0$ carrying a bit with a high value get closed, and the associated separate capacitors $C_{n-1}$, ..., $C_2$, $C_1$, $C_0$ are connected in parallel to the LC resonator 2.

Consequently, the value of the tuning capacitance $C_T$ is adjusted according to the computed tuning code B, and the resonance frequency of the LC resonator 2 is tuned to the target resonance frequency $f_t$ according to formula (2). The LC resonator 2 can be tuned to any intermediate resonance frequency in the range from $f_{min}$ to $f_{max}$ by connecting the separate capacitors $C_{n-1}$, ..., $C_2$, $C_1$, $C_0$ in parallel to the LC resonator 2 according to the bits B[n-1:0] of the tuning code B.

The resulting total capacitance $C_{total}$ comprising the capacitance $C_A$ and the variable capacitance $C_T$ is defined in formula (6):

$$C_{total} = C_A + C_0 \cdot \sum_{i=0}^{n-1} 2^i \cdot B[i] \qquad (6)$$

The resulting resonance frequency $f_{res}$ of the LC resonator is given in formula (7):

$$f_{res} = \left. 1 \middle/ 2\pi \sqrt{L_A C_{total}} \right. \qquad (7)$$

Because of the linearisation of the function according to formula (1) in a limited frequency range, only a small error results. For example, using ten bits for the frequency coding and using five separate capacitors (n=5) for tuning an LC resonator 2 with an antenna coil will result in an attenuation of the antenna smaller than one decibel (<1dB), which is more or less negligible.

## Claims

1. Method for tuning an LC resonator (2) comprising connecting a variable capacitance ($C_T$) in parallel to the LC resonator (2), the method further comprising the steps of:

    measuring a maximum resonance frequency of the LC resonator (2), the variable capacitance ($C_T$) being set to its minimum value, and storing a coded value of the maximum resonance frequency in a first memory ($F_{max}$), measuring a minimum resonance frequency of the LC resonator (2), the variable capacitance ($C_T$) being set to its maximum value, and storing a coded value of the minimum resonance frequency in a second memory ($F_{min}$), computing a tuning code (B) for setting the variable capacitance ($C_T$) to a value that results in a target resonance frequency ($f_t$) of the LC resonator, the tuning code (B) being computed as an interpolation between the coded value stored in the first memory ($F_{max}$) and the coded value stored in the second memory ($F_{min}$) for a coded value of the target resonance frequency ($f_t$), and adjusting the value of the variable capacitance ($C_T$) in accordance with the value of the computed tuning code (B).

2. Method according to claim 1, **characterised in that** adjusting the value of the variable capacitance ($C_T$) in accordance with the value of the computed tuning code (B) is done by connecting selected separate capacitors ($C_{n-1}$, ..., $C_2$, $C_1$, $C_0$) of the variable capacitance ($C_T$) in parallel to the LC resonator (2) by closing switches ($T_{n-1}$, ..., $T_2$, $T_1$, $T_0$) associated with each of the selected separate capacitors ($C_{n-1}$, ..., $C_2$, $C_1$, $C_0$) in accordance with the value of the computed tuning code (B).

3. Method according to claim 2, **characterised in that** a binary code is used for the tuning code (B), **in that** the values of the separate capacitors ($C_{n-1}$, ..., $C_2$, $C_1$, $C_0$) are binary weighted, and **in that** bits composing the tuning code (B) are assigned to the switches ($T_{n-1}$, ..., $T_2$, $T_1$, $T_0$) associated with the separate capacitors ($C_{n-1}$, ..., $C_2$, $C_1$, $C_0$) such that the binary weight of each bit corresponds to the binary weight of the separate capacitor ($C_{n-1}$, ...., $C_2$, $C_1$, $C_0$) associated with the switch ($T_{n-1}$, ..., $T_2$, $T_1$, $T_0$).

4. Method according to one of the claims 1 to 3, **characterised in that** the tuning code (B) is computed as a linear interpolation, comprising computing a ratio of the difference between the coded value stored in the first memory ($F_{max}$) and the coded value of the target resonance frequency ($f_t$) and of the difference between the coded value stored in the first memory ($F_{max}$) and the coded value stored in the second memory ($F_{min}$).

5. Method according to one of the claims 2 to 4, **characterised in that** it further comprises prior to measuring the maximum resonance frequency of the LC resonator (2), disconnecting all the separate capacitors ($C_{n-1}$, ..., $C_2$, $C_1$, $C_0$) of the variable capacitance ($C_T$) and setting a trim capacitor of the LC resonator (2) to a calibration value that results in a desired maximum resonance frequency of the LC resonator (2), and prior to measuring the minimum resonance frequency of the LC resonator (2), connecting all the separate capacitors ($C_{n-1}$, ..., $C_2$, $C_1$, $C_0$) of the

variable capacitance ($C_T$) in parallel to the LC resonator (2).

6.  Method according to one of the claims 1 to 5, **characterised in that** it comprises measuring the maximum resonance frequency and the minimum resonance frequency at manufacturing time of an electrical apparatus (1) comprising the LC resonator (2) and storing the coded values of the measured maximum resonance frequency and of the measured minimum resonance frequency in non-volatile memories.

7.  Method according to one of the claims 1 to 6, **characterised in that** an antenna coil, particularly a miniaturised antenna coil, is used as an inductance ($L_A$) of the LC resonator (2).

8.  Method according to one of the claims 2 to 6, **characterised in that** transistors are used for the switches ($T_{n-1}$, ... , $T_2$, $T_1$, $T_0$), and **in that** the transistors and the separate capacitors ($C_{n-1}$, ..., $C_2$, $C_1$, $C_0$) of the variable capacitance ($C_T$) are integrated on a chip.

9.  Method according to claim 8, **characterised in that** the separate capacitors ($C_{n-1}$, ..., $C_2$, $C_1$, $C_0$) of the variable capacitance ($C_T$) are integrated on a CMOS chip, and **in that** MOS transistors are used for the switches ($T_{n-1}$, ..., $T_2$, $T_1$, $T_0$).

10. Method according to one of the claims 1 to 9, **characterised in that** an LC resonator (2) having a resonance frequency in the VHF or UHF frequency range is used.

11. Electrical apparatus (1) comprising an LC resonator (2) and a variable capacitance ($C_T$) connected in parallel to the LC resonator (2), **characterised**
    **in that** the electrical apparatus (1) comprises a first memory ($F_{max}$), having stored therein a coded value of a maximum resonance frequency of the LC resonator (2) measured for the variable capacitance ($C_T$) set to its minimum value,
    **in that** the electrical apparatus (1) comprises a second memory ($F_{min}$), having stored therein a coded value of a minimum resonance frequency of the LC resonator (2) measured for the variable capacitance ($C_T$) set to its maximum value,
    **in that** the electrical apparatus (1) comprises computing means (3) for computing a tuning code (B) for setting the variable capacitance ($C_T$) to a value that results in a target resonance frequency ($f_t$) of the LC resonator (2), the computing means (3) being connected to the first memory ($F_{max}$) and to the second memory ($F_{min}$), and the tuning code (B) being computed as an interpolation between the coded value stored in the first memory ($F_{max}$) and the coded value stored in the second memory ($F_{min}$) for a coded value of the target resonance frequency ($f_t$), and
    **in that** the electrical apparatus (1) comprises means for adjusting the value of the variable capacitance ($C_T$) in accordance with the value of the computed tuning code (B).

12. Electrical apparatus (1) according to claim 11, **characterised in that** the variable capacitance ($C_T$) comprises several separate capacitors ($C_{n-1}$, ..., $C_2$, $C_1$, $C_0$) and switches ($T_{n-1}$, ..., $T_2$, $T_1$, $T_0$) associated with each of the separate capacitors ($C_{n-1}$, ..., $C_2$, $C_1$, $C_0$) for selectively connecting the separate capacitors ($C_{n-1}$, ..., $C_2$, $C_1$, $C_0$) in parallel to the LC resonator (2), and **in that** the electrical apparatus (1) comprises means for connecting selected ones of the separate capacitors ($C_{n-1}$, ..., $C_2$, $C_1$, $C_0$) in parallel to the LC resonator (2) by closing the switches ($T_{n-1}$, ..., $T_2$, $T_1$, $T_0$) associated with the selected separate capacitors ($C_{n-1}$, ..., $C_2$, $C_1$, $C_0$) in accordance with the value of the computed tuning code (B).

13. Electrical apparatus (1) according to claim 12, **characterised in that** the tuning code (B) is a binary code, **in that** the values of the separate capacitors ($C_{n-1}$, ..., $C_2$, $C_1$, $C_0$) are binary weighted, and **in that** the computing means (3) and the switches ($T_{n-1}$, ..., $T_2$, $T_1$, $T_0$) are connected, each connection between the computing means (3) and one of the switches ($T_{n-1}$, ..., $T_2$, $T_1$, $T_0$) carrying a bit of the tuning code (B), the binary weight of the bit corresponding to the binary weight of the separate capacitor ($C_{n-1}$, ..., $C_2$, $C_1$, $C_0$) associated with the switch.

14. Electrical apparatus (1) according to one of the claims 11 to 13, **characterised in that** the computing means (3) of the electrical apparatus (1) are designed to compute the tuning code (B) as a linear interpolation, computing a ratio of the difference between the coded value stored in the first memory ($F_{max}$) and the coded value of the target resonance frequency ($f_t$) and of the difference between the coded value stored in the first memory ($F_{max}$) and the coded value stored in the second memory ($F_{min}$).

15. Electrical apparatus (1) according to one of the claims 12 to 14, **characterised in that**, the LC resonator (2) comprises a trim capacitor for calibrating the LC resonator (2) to a desired maximum resonance frequency of the LC resonator (2) when all the separate capacitors ($C_{n-1}$, ..., $C_2$, $C_1$, $C_0$) of the variable capacitance ($C_T$) are disconnected.

16. Electrical apparatus (1) according to one of the claims 11 to 15, **characterised in that** the first memory ($F_{max}$) and the second memory ($F_{min}$) are non-volatile memories.

17. Electrical apparatus (1) according to one of the claims 11 to 16, **characterised in that** the LC resonator (2) comprises an antenna coil, particularly a miniaturised antenna coil, and **in that** the electrical apparatus (1) comprises a radio receiver (4) connected to the antenna coil.

18. Electrical apparatus (1) according to one of the claims 12 to 17, **characterised in that** the switches ($T_{n-1}$, ..., $T_2$, $T_1$, $T_0$) are transistors, and **in that** the computing means (3), the transistors and the separate capacitors ($C_{n-1}$, ..., $C_2$, $C_1$, $C_0$) of the variable capacitance ($C_T$) are integrated on a chip.

19. Electrical apparatus (1) according to claim 18, **characterised in that** the separate capacitors ($C_{n-1}$, ..., $C_2$, $C_1$, $C_0$) of the variable capacitance ($C_T$) are integrated on a CMOS chip, and **in that** the switches ($T_{n-1}$, ..., $T_2$, $T_1$, $T_0$) are MOS transistors.

20. Electrical apparatus (1) according to one of the claims 11 to 19, **characterised in that** the LC resonator (2) has a resonance frequency in the VHF or UHF frequency range.

21. Integrated circuit comprising a variable capacitance ($C_T$) for tuning an external LC resonator (2), **characterised in that** the integrated circuit comprises a first memory ($F_{max}$), for storing therein a coded value of a maximum resonance frequency of the external LC resonator (2) measured in the state of the integrated circuit being connected in parallel to the LC resonator (2), for the variable capacitance ($C_T$) set to its minimum value,
    **in that** the integrated circuit comprises a second memory ($F_{min}$), for storing therein a coded value of a minimum resonance frequency of the external LC resonator (2) measured in the state of the integrated circuit being connected in parallel to the LC resonator (2), for the variable capacitance ($C_T$) set to its maximum value,
    **in that** the integrated circuit comprises computing means (3) for computing a tuning code (B) for setting the variable capacitance ($C_T$) to a value that results in a target resonance frequency ($f_t$) of the external LC resonator (2) in the state of the integrated circuit being connected in parallel to the LC resonator (2), the computing means (3) being connected to the first memory ($F_{max}$) and to the second memory ($F_{min}$), and the tuning code (B) being computed as an interpolation between the coded value stored in the first memory ($F_{max}$) and the coded value stored in the second memory ($F_{min}$) for a coded value of the target resonance frequency ($f_t$), and
    **in that** the integrated circuit comprises means for adjusting the value of the variable capacitance ($C_T$) in accordance with the value of the computed tuning code (B).

22. Integrated circuit according to claim 21, **characterised in that** the variable capacitance ($C_T$) of the integrated circuit comprises several separate capacitors ($C_{n-1}$, ..., $C_2$, $C_1$, $C_0$) and switches ($T_{n-1}$, ..., $T_2$, $T_1$, $T_0$) associated with each of the separate capacitors ($C_{n-1}$, ..., $C_2$, $C_1$, $C_0$) for selectively connecting the separate capacitors ($C_{n-1}$, ..., $C_2$, $C_1$, $C_0$) in parallel to the external LC resonator (2), and **in that** the integrated circuit comprises means for connecting selected ones of the separate capacitors ($C_{n-1}$, ..., $C_2$, $C_1$, $C_0$) in parallel to the external LC resonator (2) by closing the switches ($T_{n-1}$, ..., $T_2$, $T_1$, $T_0$) associated with the selected separate capacitors ($C_{n-1}$, ..., $C_2$, $C_1$, $C_0$) in accordance with the value of the computed tuning code (B).

23. Integrated circuit according to claim 22, **characterised in that** the tuning code (B) is a binary code, **in that** the values of the separate capacitors ($C_{n-1}$, ..., $C_2$, $C_1$, $C_0$) are binary weighted, and **in that** the computing means (3) and the switches ($T_{n-1}$, ..., $T_2$, $T_1$, $T_0$) are connected, each connection between the computing means (3) and one of the switches ($T_{n-1}$, ..., $T_2$, $T_1$, $T_0$) carrying a bit of the tuning code (B), the binary weight of the bit corresponding to the binary weight of the separate capacitor ($C_{n-1}$, $C_2$, $C_1$, $C_0$) associated with the switch.

24. Integrated circuit according to one of the claims 21 or 23, **characterised in that** the computing means (3) are designed to compute the tuning code (B) as a linear interpolation, computing a ratio of the difference between the coded value stored in the first memory ($F_{max}$) and the coded value of the target resonance frequency ($f_t$) and of the difference between the coded value stored in the first memory ($F_{max}$) and the coded value stored in the second memory ($F_{min}$).

25. Integrated circuit according to one of the claims 21 to 24, **characterised in that** the first memory ($F_{max}$) and the

second memory ($F_{min}$) are non-volatile memories.

26. Integrated circuit according to one of the claims 21 to 25, **characterised in that** the separate capacitors ($C_{n-1}$, ..., $C_2$, $C_1$, $C_0$) are integrated on a CMOS chip, and **in that** the switches ($T_{n-1}$,..., $T_2$, $T_1$, $T_0$) are MOS transistors.

## Patentansprüche

1. Verfahren zur Abstimmung eines LC-Resonators (2), das eine zum LC-Resonator (2) parallele Zuschaltung einer variablen Kapazität ($C_T$) umfasst, wobei das Verfahren außerdem folgende Schritte umfasst:

   Messen einer maximalen Resonanzfrequenz des LC-Resonators (2), wobei die variable Kapazität ($C_T$) auf ihren minimalen Wert eingestellt wird, und Speichern eines codierten Wertes der maximalen Resonanzfrequenz in einem ersten Speicher ($F_{max}$),
   Messen einer minimalen Resonanzfrequenz des LC-Resonators (2), wobei die variable Kapazität ($C_T$) auf ihren maximalen Wert eingestellt wird, und Speichern eines codierten Wertes der minimalen Resonanzfrequenz in einem zweiten Speicher ($F_{min}$),
   Berechnen eines Abstimmcodes (B) zur Einstellung der variablen Kapazität ($C_T$) auf einen Wert, mit dem eine Soll-Resonanzfrequenz ($f_t$) des LC-Resonators erhalten wird, wobei der Abstimmcode (B) als eine Interpolierung für einen codierten Wert der Soll-Resonanzfrequenz ($f_t$) zwischen dem im ersten Speicher ($F_{max}$) abgelegten, codierten Wert und dem im zweiten Speicher ($F_{min}$) abgelegten, codierten Wert berechnet wird und
   Regelung des Wertes der variablen Kapazität ($C_T$) entsprechend dem Wert des berechneten Abstimmcodes (B).

2. Verfahren nach Anspruch 1, **dadurch gekennzeichnet, dass** die Regelung des Wertes der variablen Kapazität ($C_T$) entsprechend dem Wert des berechneten Abstimmcodes (B) durch zum LC-Resonator (2) parallele Zuschaltung von ausgewählten separaten Kondensatoren ($C_{n-1}$, ..., $C_2$, $C_1$, $C_0$) der variablen Kapazität ($C_T$) mittels Schließen von Schaltern ($T_{n-1}$, ..., $T_2$, $T_1$, $T_0$) vorgenommen wird, die jedem der entsprechend dem Wert des berechneten Abstimmcodes (B) ausgewählten separaten Kondensatoren ($C_{n-1}$, ..., $C_2$, $C_1$, $C_0$) zugeordnet sind.

3. Verfahren nach Anspruch 2, **dadurch gekennzeichnet, dass** ein Binärcode als Abstimmcode (B) benutzt wird, dass die Werte der separaten Kondensatoren ($C_{n-1}$, ..., $C_2$, $C_1$, $C_0$) binär gewichtet werden, und dass die den Abstimmcode (B) bildenden Bits den Schaltern ($T_{n-1}$, ..., $T_2$, $T_1$, $T_0$) zugewiesen werden, die den separaten Kondensatoren ($C_{n-1}$, ..., $C_2$, $C_1$, $C_0$) zugeordnet sind, so dass die binäre Wertigkeit jedes Bits der binären Wertigkeit des dem Schalter ($T_{n-1}$, ..., $T_2$, $T_1$, $T_0$) zugeordneten separaten Kondensators ($C_{n-1}$, ..., $C_2$, $C_1$, $C_0$) entspricht.

4. Verfahren nach einem der Ansprüche 1 bis 3, **dadurch gekennzeichnet, dass** der Abstimmcode (B) als eine lineare Interpolierung berechnet wird, welche die Berechnung eines Verhältnisses der Differenz zwischen dem codierten, im ersten Speicher ($F_{max}$) abgelegten Wert und dem codierten Wert der Soll-Resonanzfrequenz ($f_t$) und der Differenz zwischen dem codierten, im ersten Speicher abgelegten Wert ($F_{max}$) und dem codierten, im zweiten ($F_{min}$) Speicher abgelegten Wert umfasst.

5. Verfahren nach einem der Ansprüche 2 bis 4, **dadurch gekennzeichnet, dass** es außerdem vor dem Messen der maximalen Resonanzfrequenz des LC-Resonators (2) die Trennung aller separaten Kondensatoren ($C_{n-1}$, ..., $C_2$, $C_1$, $C_0$) von der variablen Kapazität ($C_T$) und die Einstellung eines Trimmkondensators des LC-Resonators (2) auf einen Kalibrierwert, mit dem eine gewünschte maximale Resonanzfrequenz des LC-Resonators (2) erhalten wird, umfasst, und dass vor dem Messen der minimalen Resonanzfrequenz des LC-Resonators (2) die zum LC-Resonator (2) parallele Zuschaltung aller separaten Kondensatoren ($C_{n-1}$, ..., $C_2$, $C_1$, $C_0$) der variablen Kapazität ($C_T$) umfasst.

6. Verfahren nach einem der Ansprüche 1 bis 5, **dadurch gekennzeichnet, dass** es die Messung der maximalen Resonanzfrequenz und der minimalen Resonanzfrequenz während der Herstellung eines den LC-Resonator (2) aufweisenden Elektrogerätes (1) und die Speicherung der gemessenen maximalen Resonanzfrequenz sowie der gemessenen minimalen Resonanzfrequenz in nichtflüchtigen Speichern umfasst.

7. Verfahren nach einem der Ansprüche 1 bis 6, **dadurch gekennzeichnet, dass** eine Antennenspule, und insbesondere eine miniaturisierte Antennenspule als Induktivität ($L_A$) des LC-Resonators (2) verwendet wird.

8. Verfahren nach einem der Ansprüche 2 bis 6, **dadurch gekennzeichnet, dass** für die Schalter ($T_{n-1}$, ..., $T_2$, $T_1$, $T_0$) Transistoren verwendet werden, und dass die Transistoren und die separaten Kondensatoren ($C_{n-1}$, ..., $C_2$, $C_1$,

$C_0$) der variablen Kapazität ($C_T$) auf einem Chip integriert sind.

9. Verfahren nach Anspruch 8, **dadurch gekennzeichnet, dass** die separaten Kondensatoren ($C_{n-1}$, ..., $C_2$, $C_1$, $C_0$) der variablen Kapazität ($C_T$) auf einem CMOS-Chip integriert sind, und dass für die Schalter ($T_{n-1}$, ..., $T_2$, $T_1$, $T_0$) MOS-Transistoren verwendet werden.

10. Verfahren nach einem der Ansprüche 1 bis 9, **dadurch gekennzeichnet, dass** ein LC-Resonator (2) mit einer Resonanzfrequenz im VHF- oder UHF-Frequenzbereich verwendet wird.

11. Elektrogerät (1), das einen LC-Resonator (2) und eine parallel zum LC-Resonator (2) geschaltete, variable Kapazität ($C_T$) aufweist, **dadurch gekennzeichnet,**
    **dass** das Elektrogerät (1) einen ersten Speicher ($F_{max}$) aufweist, in dem ein codierter Wert einer maximalen Resonanzfrequenz des LC-Resonators (2) gespeichert ist, der für die auf ihren minimalen Wert eingestellte, variable Kapazität ($C_T$) gemessen wurde,
    **dass** das Elektrogerät (1) einen zweiten Speicher ($F_{min}$) aufweist, in dem ein codierter Wert einer minimalen Resonanzfrequenz des LC-Resonators (2) gespeichert ist, der für die auf ihren maximalen Wert eingestellte, variable Kapazität ($C_T$) gemessen wurde,
    **dass** das Elektrogerät (1) ein Rechenmittel (3) zur Berechnung eines Abstimmcodes (B) zur Einstellung der variablen Kapazität ($C_T$) auf einen Wert aufweist, mit dem eine Soll-Resonanzfrequenz ($f_t$) des LC-Resonators (2) erhalten wird, wobei das Rechenmittel (3) mit dem ersten Speicher ($F_{max}$) und mit dem zweiten Speicher ($F_{min}$) verbunden ist, und der Abstimmcode (B) als eine Interpolierung für einen codierten Wert der Soll-Resonanzfrequenz ($f_t$) zwischen dem im ersten Speicher ($F_{max}$) abgelegten, codierten Wert und dem im zweiten Speicher ($F_{min}$) abgelegten, codierten Wert berechnet wird, und
    **dass** das Elektrogerät (1) Mittel zur Regelung des Wertes der variablen Kapazität ($C_T$) entsprechend des Wertes des berechneten Abstimmcodes (B) aufweist.

12. Elektrogerät (1) nach Anspruch 11, **dadurch gekennzeichnet, dass** die variable Kapazität ($C_T$) mehrere separate Kondensatoren ($C_{n-1}$, ..., $C_2$, $C_1$, $C_0$) und zu jedem der separaten Kondensatoren ($C_{n-1}$, ..., $C_2$, $C_1$, $C_0$) zugeordnete Schalter ($T_{n-1}$, ..., $T_2$, $T_1$, $T_0$) zur wahlweisen, zum LC-Resonator (2) parallelen Zuschaltung der separaten Kondensatoren ($C_{n-1}$, ..., $C_2$, $C_1$, $C_0$) aufweist, und dass das Elektrogerät (1) Mittel zur zum LC-Resonator (2) parallelen Zuschaltung von unter den separaten Kondensatoren ($C_{n-1}$, ..., $C_2$, $C_1$, $C_0$) ausgewählten Kondensatoren durch Schließen der Schalter ($T_{n-1}$, ..., $T_2$, $T_1$, $T_0$) aufweist, die jedem der entsprechend dem Wert des berechneten Abstimmcodes (B) ausgewählten separaten Kondensatoren ($C_{n-1}$, ..., $C_2$, $C_1$, $C_0$) zugeordnet sind.

13. Elektrogerät (1) nach Anspruch 12, **dadurch gekennzeichnet, dass** der Abstimmcode (B) ein Binärcode ist, dass die Werte der separaten Kondensatoren ($C_{n-1}$, ..., $C_2$, $C_1$, $C_0$) binär gewichtet werden, und dass das Rechenmittel (3) und die Schalter ($T_{n-1}$, ..., $T_2$, $T_1$, $T_0$) miteinander verbunden sind, wobei jede Verbindung zwischen dem Rechenmittel (3) und einem der Schalter ($T_{n-1}$, ..., $T_2$, $T_1$, $T_0$) ein Bit des Abstimmcodes (B) überträgt und die binäre Wertigkeit des Bits der binären Wertigkeit des dem Schalter zugeordneten, separaten Kondensators ($C_{n-1}$, ..., $C_2$, $C_1$, $C_0$) entspricht.

14. Elektrogerät (1) nach einem der Ansprüche 11 bis 13, **dadurch gekennzeichnet, dass** das Rechenmittel (3) des Elektrogerätes (1) zur linearen Interpolierung des Abstimmcodes (B) konzipiert ist, wobei es ein Verhältnis der Differenz zwischen dem codierten, im ersten Speicher ($F_{max}$) abgelegten Wert und dem codierten Wert der Soll-Resonanzfrequenz ($f_t$) und der Differenz zwischen dem codierten, im ersten Speicher abgelegten Wert ($F_{max}$) und dem codierten, im zweiten ($F_{min}$) Speicher abgelegten Wert berechnet.

15. Elektrogerät (1) nach einem der Ansprüche 12 bis 14, **dadurch gekennzeichnet, dass** der LC-Resonator (2) einen Trimmkondensator aufweist, um den LC-Resonator (2) auf eine gewünschte maximale Resonanzfrequenz des LC-Resonators zu kalibrieren, wenn alle separaten Kondensatoren ($C_{n-1}$, ..., $C_2$, $C_1$, $C_0$) der variablen Kapazität ($C_T$) getrennt sind.

16. Elektrogerät (1) nach einem der Ansprüche 11 bis 15, **dadurch gekennzeichnet, dass** der erste Speicher ($F_{max}$) und der zweite Speicher ($F_{min}$) nichtflüchtige Speicher sind.

17. Elektrogerät (1) nach einem der Ansprüche 11 bis 16, **dadurch gekennzeichnet, dass** der LC-Resonator (2) eine Antennenspule und insbesondere eine miniaturisierte Antennenspule aufweist, und dass das Elektrogerät (1) einen an diese Antennenspule angeschlossenen Funkempfänger (4) aufweist.

**18.** Elektrogerät (1) nach einem der Ansprüche 12 bis 17, **dadurch gekennzeichnet, dass** die Schalter ($T_{n-1}$, ..., $T_2$, $T_1$, $T_0$) Transistoren sind, und dass das Rechenmittel (3), die Transistoren und die separaten Kondensatoren ($C_{n-1}$, ..., $C_2$, $C_1$, $C_0$) der variablen Kapazität ($C_T$) auf einem Chip integriert sind.

**19.** Elektrogerät (1) nach Anspruch 18, **dadurch gekennzeichnet, dass** die separaten Kondensatoren ($C_{n-1}$, ..., $C_2$, $C_1$, $C_0$) der variablen Kapazität ($C_T$) auf einem CMOS-Chip integriert sind, und dass für die Schalter ($T_{n-1}$, ..., $T_2$, $T_1$, $T_0$) MOS-Transistoren verwendet werden.

**20.** Elektrogerät (1) nach einem der Ansprüche 11 bis 19, **dadurch gekennzeichnet, dass** der LC-Resonator (2) mit einer Resonanzfrequenz im VHF- oder UHF-Frequenzbereich verwendet wird.

**21.** Integrierte Schaltung, die eine variable Kapazität ($C_T$) zur Abstimmung eines externen LC-Resonators (2) aufweist, **dadurch gekennzeichnet,**
**dass** die integrierte Schaltung einen ersten Speicher ($F_{max}$) aufweist, um in ihm einen codierten Wert einer maximalen Resonanzfrequenz des externen LC-Resonators (2) zu speichern, der im parallel zum LC-Resonator (2) zugeschalteten Zustand der integrierten Schaltung für die auf ihren minimalen Wert eingestellte, variable Kapazität ($C_T$) gemessen wurde,
**dass** die integrierte Schaltung einen zweiten Speicher ($F_{min}$) aufweist, um in ihm einen codierten Wert einer minimalen Resonanzfrequenz des externen LC-Resonators (2) zu speichern, der im parallel zum LC-Resonator (2) zugeschalteten Zustand der integrierten Schaltung für die auf ihren maximalen Wert eingestellte, variable Kapazität ($C_T$) gemessen wurde,
**dass** die integrierte Schaltung Rechenmittel (3) zur Berechnung eines Abstimmcodes (B) zur Einstellung der variablen Kapazität ($C_T$) auf einen Wert aufweist, mit dem eine Soll-Resonanzfrequenz ($f_t$) des externen LC-Resonators (2) im parallel zum LC-Resonator (2) zugeschalteten Zustand der integrierten Schaltung erhalten wird, wobei das Rechenmittel (3) mit dem ersten Speicher ($F_{max}$) und mit dem zweiten Speicher ($F_{min}$) verbunden ist und der Abstimmcode (B) als eine Interpolierung für einen codierten Wert der Soll-Resonanzfrequenz ($f_t$) zwischen dem im ersten Speicher ($F_{max}$) abgelegten, codierten Wert und dem im zweiten Speicher ($F_{min}$) abgelegten, codierten Wert berechnet wird, und
**dass** die integrierte Schaltung Mittel zur Regelung des Wertes der variablen Kapazität ($C_T$) entsprechend des Wertes des berechneten Abstimmcodes (B) aufweist.

**22.** Integrierte Schaltung nach Anspruch 21, **dadurch gekennzeichnet, dass** die variable Kapazität ($C_T$) der integrierten Schaltung mehrere separate Kondensatoren ($C_{n-1}$, ..., $C_2$, $C_1$, $C_0$) und zu jedem der separaten Kondensatoren ($C_{n-1}$, ... , $C_2$, $C_1$, $C_0$) zugeordnete Schalter ($T_{n-1}$, ..., $T_2$, $T_1$, $T_0$) zur wahlweisen, zum externen LC-Resonator (2) parallelen Zuschaltung der separaten Kondensatoren ($C_{n-1}$, ..., $C_2$, $C_1$, $C_0$) aufweist, und dass die integrierte Schaltung Mittel zur zum externen LC-Resonator (2) parallelen Zuschaltung von unter den separaten Kondensatoren ($C_{n-1}$, ..., $C_2$, $C_1$, $C_0$) ausgewählten Kondensatoren durch Schließen der Schalter ($T_{n-1}$, ..., $T_2$, $T_1$, $T_0$) aufweist, die den entsprechend dem Wert des berechneten Abstimmcodes (B) ausgewählten separaten Kondensatoren ($C_{n-1}$, ..., $C_2$, $C_1$, $C_0$) zugeordnet sind.

**23.** Integrierte Schaltung nach Anspruch 22, **dadurch gekennzeichnet, dass** der Abstimmcode (B) ein Binärcode ist, dass die Werte der separaten Kondensatoren ($C_{n-1}$, ..., $C_2$, $C_1$, $C_0$) binär gewichtet werden, und dass das Rechenmittel (3) und die Schalter ($T_{n-1}$, ..., $T_2$, $T_1$, $T_0$) miteinander verbunden sind, wobei, jede Verbindung zwischen dem Rechenmittel (3) und einem der Schalter ($T_{n-1}$, ..., $T_2$, $T_1$, $T_0$) ein Bit des Abstimmcodes (B) überträgt, wobei die binäre Wertigkeit des Bits der binären Wertigkeit des dem Schalter zugeordneten separaten Kondensators ($C_{n-1}$, ..., $C_2$, $C_1$, $C_0$) entspricht.

**24.** Integrierte Schaltung nach einem der Ansprüche 21 bis 23, **dadurch gekennzeichnet, dass** die Rechenmittel (3) zur Berechnung des Abstimmcodes (B) als lineare Interpolierung konzipiert sind, wobei sie ein Verhältnis der Differenz zwischen dem codierten, im ersten Speicher ($F_{max}$) abgelegten Wert und dem codierten Wert der Soll-Resonanzfrequenz ($f_t$) und der Differenz zwischen dem codierten, im ersten Speicher abgelegten Wert ($F_{max}$) und dem codierten, im zweiten ($F_{min}$) Speicher abgelegten Wert berechnen.

**25.** Integrierte Schaltung nach einem der Ansprüche 21 bis 24, **dadurch gekennzeichnet, dass** der erste Speicher ($F_{max}$) und der zweite Speicher ($F_{min}$) nichtflüchtige Speicher sind.

**26.** Integrierte Schaltung nach einem der Ansprüche 21 bis 25, **dadurch gekennzeichnet, dass** die separaten Kondensatoren ($C_{n-1}$, ..., $C_2$, $C_1$, $C_0$) auf einem CMOS-Chip integriert sind, und dass für die Schalter ($T_{n-1}$, ..., $T_2$, $T_1$,

$T_0$) MOS-Transistoren verwendet werden.

**Revendications**

1. Procédé pour l'accord d'un résonateur LC (2) comprenant une capacitance variable (CT) en parallèle au résonateur LC (2), le procédé comprenant en outre les étapes de
mesure de la fréquence de résonance maximale du résonateur LC (2), la capacitance variable (CT) étant réglée à sa valeur minimale et stockage d'une valeur codée de la fréquence de résonance maximale dans une première mémoire (Fmax),
mesure d'une fréquence de résonance minimale du résonateur LC (2), la capacitance variable (CT) étant réglée à sa valeur minimale et stockage d'une valeur codée de la fréquence de résonance minimale dans une seconde mémoire (Fmin),
calcul d'un code d'accord (B) pour le réglage de la capacitance variable (CT) à une valeur qui résulte en une fréquence cible de résonance (ft) du résonateur LC, le code d'accord (B) étant calculé comme une interpolation entre la valeur codée stockée dans la première mémoire (Fmax) et la valeur stockée dans la seconde mémoire (Fmin) pour une valeur codée de la fréquence cible de résonance (ft), et
ajustement de la valeur de la capacitance variable (CT) en fonction de la valeur du code d'accord calculé (B).

2. Procédé selon la revendication 1, **caractérisé en ce que** l'ajustement de la valeur de la capacitance variable (CT) selon la valeur du code d'accord calculé (B) est effectué en connectant des capaciteurs sélectionnés séparés (Cn-1, ..., C2, C1, C0) de la capacitance variable (CT) en parallèle au résonateur LC (2) en formant des commutateurs (Tn-1, ..., T2, T1, T0) associés à chacun des capaciteurs séparés sélectionnés (Cn-1, ..., C2, C1, C0) selon la valeur du code d'accord calculé (B).

3. Procédé selon la revendication 2, **caractérisé en ce qu'**un code binaire est utilisé pour le code d'accord (B), **en ce que** les valeurs des capaciteurs séparés (Cn-1, ..., C2, C1, C0) sont pondérées de manière binaire et **en ce que** les bits composant le code d'accord (B) sont attribués aux commutateurs (Tn-1, ..., T2, T1, T0) associés aux capaciteurs séparés (Cn-1, ..., C2, C1, C0) de sorte que le poids binaire de chaque bit correspond au poids binaire du capaciteur séparé (Cn-1, ..., C2, C1, C0) associé au commutateur (Tn-1, ..., T2, T1, T0).

4. Procédé selon l'une des revendications 1 à 3 **caractérisé en ce que** le code d'accord (B) est calculé en tant qu'interpolation linéaire, comprenant le calcul d'un rapport de la différence entre la valeur codée stockée dans la première mémoire (Fmax) et la valeur codée de la fréquence de résonance cible (ft) et de la différence entre la valeur codée stockée dans la première mémoire (Fmax) et la valeur codée stockée dans la seconde mémoire (Fmin).

5. Procédé selon l'une des revendications 2 à 4, **caractérisé en ce qu'**il comprend en outre avant la mesure de la fréquence de résonance maximale du résonateur LC (2), la déconnexion de tous les capaciteurs séparés (Cn-1, ..., C2, C1, C0) de la capacitance variable (CT) et réglage d'un capaciteur d'ajustement du résonateur LC (2) à une valeur de calibrage qui aboutit à une fréquence de résonance maximale recherchée du résonateur LC (2), et avant la mesure de la fréquence de résonance minimale du résonateur LC (2), connexion de tous les capaciteurs séparés (Cn-1, ..., C2, C1, C0) de la capacitance variable (CT) en parallèle au résonateur LC (2).

6. Procédé selon l'une des revendications 1 à 5, **caractérisé en ce qu'**il comprend la mesure de la fréquence de résonance maximale et de la fréquence de résonance minimale à des temps de fabrication d'un appareil électrique (1) comprenant le résonateur LC (2) et stockage des valeurs codées de la fréquence de résonance maximale et de la fréquence de résonance mesurée minimale dans des mémoires non-volatiles

7. Procédé selon l'une des revendications 1 à 6, **caractérisé en ce qu'**une bobine d'antenne, en particulier une bobine d'antenne miniaturisée, est utilisée en tant qu'inductance (LA) du résonateur LC (2).

8. Procédé selon l'une des revendications 2 à 6, **caractérisé en ce que** des transistors sont utilisés pour les commutateurs (Tn-1, ..., T2, T1, T0), et **en ce que** les transistors et les capaciteurs séparés (Cn-1, ..., C2, C1, C0) de la capacitance variable (CT) sont intégrés sur une puce.

9. Procédé selon la revendication 8, **caractérisé en ce que** les capaciteurs séparés (Cn-1, ..., C2, C1, C0) de la capacitance variable (CT) sont intégrés sur une puce CMOS et **en ce que** les transistors MOS sont utilisés pour les commutateurs (Tn-1, ..., T2, T1, T0).

**10.** Procédé selon l'une des revendications 1 à 9, **caractérisé en ce qu'**un résonateur LC (2) ayant une fréquence de résonance comprise dans la plage de fréquence VHF ou UHF est utilisé

**11.** Appareil électrique (1) comprenant un résonateur LC (2) et une capacitance variable (CT) connectée en parallèle au résonateur LC (2), **caractérisé en ce que**
l'appareil électrique (1) comprend une première mémoire (Fmax), ayant une valeur codée d'une fréquence de résonance maximale du résonateur LC (2) mesurée pour la capacitance variable (CT) réglée à sa valeur minimale, **en ce que** l'appareil électrique (1) comprend une seconde mémoire (Fmin), ayant une valeur codée d'une fréquence de résonance minimale du résonateur LC (2) mesurée pour la capacitance variable (CT) réglée à sa valeur maximale **en ce que** l'appareil électrique (1) comprend des moyens de calcul (3) pour le calcul d'un code d'accord (B) pour le réglage de la capacitance variable (CT) à une valeur qui aboutit à une fréquence de résonance cible (ft) du résonateur LC (2), les moyens de calcul (3) étant connectés à la première mémoire (Fmax) et à la seconde mémoire (Fmin), et le code d'accord (B) étant calculé en tant qu'interpolation entre les valeurs codées stockées dans la première mémoire (Fmax) et la valeur codée stockée dans la seconde mémoire (Fmin) pour une valeur codée de la fréquence de résonance cible (ft),
et **en ce que** l'appareil électrique (1) comprend des moyens pour l'ajustement de la capacitance variable (CT) en fonction de la valeur du code d'accord calculé (B).

**12.** Appareil électrique (1), selon la revendication 11, **caractérisé en ce que** la capacitance variable (CT) comprend plusieurs capaciteurs séparés (Cn-1, ..., C2, C1, C0) et des commutateurs (Tn-1, ..., T2, T1, T0) associés à chacun des capaciteurs séparés (Cn-1, ..., C2, C1, C0) pour la connexion sélective des capaciteurs séparés (Cn-1, ..., C2, C1, C0) en parallèle avec le résonateur LC (2), et **en ce que** l'appareil électrique (1) comprend des moyens pour la connexion des capaciteurs séparés sélectionnés (Cn-1, ..., C2, C1, C0) en parallèle au résonateur LC (2) en formant les commutateurs (Tn-1, ..., T2, T1, T0) associés aux capaciteurs séparés (Cn-1, ..., C2, C1, C0) selon la valeur du code d'accord calculé (B).

**13.** Appareil électrique (1) selon la revendication 12, **caractérisé en ce que** le tube d'accord (B) est un code binaire, **en ce que** les valeurs des capaciteurs séparés(Cn-1, ..., C2, C1, C0) sont pesés de manière binaire et **en ce que** les moyens de calcul (3) et les commutateurs (Tn-1, ..., T2, T1, T0) sont connectés, chaque connexion entre les moyens de calcul (3) et l'un des commutateurs (Tn-1, ..., T2, T1, T0) portant un bit du code d'accord (B), le poids binaire du bit correspondant au poids binaire du capaciteur séparé (Cn-1, ..., C2, C1, C0) associé au commutateur.

**14.** Appareil électrique (1) selon l'une des revendications 11 à 13, **caractérisé en ce que** les moyens de calcul (3) de l'appareil électrique (1) sont conçus pour calculer le code d'accord (B) en tant qu'interpolation linéaire, et calculer un rapport de la différence entre la valeur codée stockée dans la première mémoire (Fmax) et la valeur codée de la fréquence de résonance cible (ft) et de la différence entre la valeur codée stockée dans la première mémoire (Fmax) et la valeur codée stockée dans la seconde mémoire (Fmin

**15.** Appareil électrique (1) selon l'une des revendications 12 à 14, **caractérisé en ce que** le résonateur LC (2) comprend un capaciteur d'ajustement pour le calibrage du résonateur LC (2) à une fréquence de résonance maximale souhaitée du résonateur LC (2) quand tous les capaciteurs séparés (Cn-1, ..., C2, C1, C0) de la capacitance variable (CT) sont déconnectés.

**16.** Appareil électrique (1) selon l'une des revendications 11 à 15, **caractérisé en ce que** la première mémoire (Fmax) et la seconde mémoire (Fmin) sont des mémoires non volatiles.

**17.** Appareil électrique (1) selon l'une des revendications 11 à 16, **caractérisé en ce que** le résonateur LC (2) comprend une bobine d'antenne, en particulier une bobine d'antenne miniaturisée et **en ce que** l'appareil électrique (1) comprend un récepteur radio (4) connecté à la bobine d'antenne.

**18.** Appareil électrique (1) selon l'une des revendications 12 à 17, **caractérisé en ce que** les commutateurs ((Tn-1, ..., T2, T1, T0) sont des transistors et **en ce que** les moyens de calcul (3), les transistors et les capaciteurs séparés (Cn-1, ..., C2, C1, C0) de la capacitance variable (CT) sont intégrés sur une puce

**19.** Appareil électrique (1) selon la revendication 18, **caractérisé en ce que** les capaciteurs séparés (Cn-1, ..., C2, C1, C0) de la capacitance variable (CT) sont intégrés sur une puce CMOS et **en ce que** les commutateurs (Tn-1, ..., T2, T1, T0) sont des transistors MOS.

**20.** Appareil électrique (1) selon l'une des revendications 11 à 19, **caractérisé en ce que** le résonateur LC (2) a une fréquence de résonance comprise dans la plage de fréquence VHF ou UHF.

**21.** Circuit intégré comprenant une capacitance variable (CT) pour l'accord d'un résonateur LC externe (2), **caractérisé en ce que** le circuit intégré comprend une première mémoire (Fmax), pour le stockage d'une valeur codée d'une fréquence de résonance maximale du résonateur LC externe (2) mesurée dans l'état du circuit intégré connecté en parallèle au résonateur LC (2), pour la capacitance variable (CT) réglée à sa valeur minimale,
**en ce que** le circuit intégré comprend une seconde mémoire (Fmin), pour le stockage d'une valeur codée d'une fréquence de résonance minimale du résonateur LC externe (2) mesurée dans l'état du circuit intégré connecté en parallèle au résonateur LC (2), pour la capacitance variable (CT) réglée à sa valeur maximale,
**en ce que** le circuit intégré comprend des moyens de calcul (3) pour calculer un code d'accord (B) pour le réglage de la capacitance variable (CT) à une valeur aboutissant à une fréquence de résonance cible (ft) du résonateur LC externe (2) dans l'état du circuit intégré connecté en parallèle au résonateur LC (2), les moyens de calcul (3) connectés à la première mémoire (Fmax) et à la seconde mémoire (Fmin), et le code d'accord (B) étant calculé en tant qu'interpolation entre la valeur codée stockée dans la première mémoire (Fmax) et la valeur codée stockée dans la seconde mémoire (Fmin) pour une valeur codée de la fréquence de résonance cible (ft), et
**en ce que** le circuit intégré comprend des moyens pour l'ajustement de la valeur de la capacitance variable (CT) selon la valeur du code d'accord calculé (B).

**22.** Circuit intégré selon la revendication 21, **caractérisé en ce que** la capacitance variable (CT) du circuit intégré comprend plusieurs capaciteurs séparés (Cn-1, ..., C2, C1, C0) et des commutateurs (Tn-1, ..., T2, T1, T0) associés à chacun des capaciteurs séparés (Cn-1, ..., C2, C1, C0) pour connecter sélectivement les capacitances variables (Cn-1, ..., C2, C1, C0) en parallèle au résonateur LC (2) et **en ce que** le circuit intégré comprend des moyens pour connecter l'un des capaciteurs séparés (Cn-1, ..., C2, C1, C0) en parallèle au résonateur externe LC (2) en fermant les commutateurs (Tn-1, ..., T2, T1, T0) associés aux capaciteurs séparés sélectionnées (Cn-1, ..., C2, C1, C0) selon la valeur du code d'accord calculé (B).

**23.** Circuit intégré selon la revendication 22, **caractérisé en ce que** le code d'accord (B) est un code binaire, **en ce que** les valeurs des capaciteurs séparés (Cn-1, ..., C2, C1, C0) sont pondérés binaires et **en ce que** les moyens de calcul (3) et les commutateurs (Tn-1, ..., T2, T1, T0) sont connectés et, chaque connexion entre les moyens de calcul (3) et l'un des commutateurs (Tn-1, ..., T2, T1, T0) portant un bit du code d'accord (B), le poids binaire du bit correspondant au poids binaire du capaciteur séparé (Cn-1, ..., C2, C1, C0) associé au commutateur.

**24.** Circuit intégré selon l'une des revendications 21 ou 23, **caractérisé en ce que** les moyens de calcul (3) sont conçus pour calculer le code d'accord (B) en tant qu'une interpolation linéaire, pour calculer le rapport de la différence entre la valeur codée stockée dans la première mémoire (Fmax) et de la valeur codée de la fréquence de résonance cible (ft) et de la différence entre la valeur codée stockée dans la première mémoire (Fmax) et la valeur codée stockée dans la seconde mémoire (Fmin).

**25.** Circuit intégré selon l'une des revendications 21 à 24, **caractérisé en ce que** la première mémoire (Fmax) et la seconde mémoire (Fmin) sont des mémoires non volatiles.

**26.** Circuit intégré selon l'une des revendications 21 à 24, **caractérisé en ce que** les capaciteurs séparés (Cn-1, ..., C2, C1, C0) sont intégrés sur une puce CMOS et **en ce que** les commutateurs (Tn-1, ..., T2, T1, T0) sont des transistors MOS.

**FIG. 1**

**FIG. 2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4862516 A
- US 5438688 A
- US 5589844 A
- US 5491715 A